# EUROPEAN PATENT SPECIFICATION

(11) **EP 3 206 236 B1**
(45) Date of publication and mention of the grant of the patent: **11.12.2019**
(21) Application number: 15852603.8
(22) Date of filing: 11.10.2015
(51) Int. Cl.: H01L 31/18, C25D 5/08, C25D 7/12, C25D 17/00, C25D 5/00, C25D 5/02

(54) **METHOD FOR HORIZONTALLY ELECTROCHEMICALLY DEPOSITING METAL**
VERFAHREN ZUR HORIZONTALEN ELEKTROCHEMISCHEN ABSCHEIDUNG VON METALL
PROCÉDÉ DE DÉPÔT ÉLECTROCHIMIQUE HORIZONTAL DE MÉTAL

(30) Priority: 20.10.2014 CN 201410557444
(43) Date of publication of application: 16.08.2017
(73) Proprietor: Sharesun Co., Ltd, Suzhou, Jiangsu 215104 (CN)
(72) Inventor: JI, Jingjia, Shanghai 200081 (CN); QIN, Yusen, Wuxi Jiangsu 214191 (CN); ZHU, Fan, Wuxi Jiangsu 214028 (CN)
(74) Representative: Westphal, Mussgnug & Partner Patentanwälte mbB
(86) International application number: PCT/CN2015/091697
(87) International publication number: WO 2016/062206

(56) References cited:
- WO-A2-2014/076078
- CN-A- 1 300 882
- CN-A- 101 257 059
- CN-A- 103 834 982
- JP-A- 2011 225 923
- TW-A- 201 347 001
- US-A- 4 183 799
- US-A- 4 251 327
- US-A1- 2006 163 078
- US-A1- 2007 256 937
- US-A1- 2011 062 028
- US-A1- 2012 043 215
- US-A1- 2014 154 836
- M. BALUCANI ET AL: "New Selective Processing Technique for Solar Cells", ENERGY PROCEDIA, vol. 43, 2013, pages 54-65, XP055412826, NL ISSN: 1876-6102, DOI: 10.1016/j.egypro.2013.11.088
- ALISON LENNON ET AL: "Evolution of metal plating for silicon solar cell metallisation", PROGRESS IN PHOTOVOLTAICS: RESEARCH AND APPLICATIONS, vol. 21, no. 7, 25 November 2013 (2013-11-25), pages 1454-1468, XP055123167, ISSN: 1062-7995, DOI: 10.1002/pip.2221

## Description

### TECHNICAL FIELD OF THE INVENTION

The present invention relates to a method for electrochemically depositing metal, and more particularly, to a method for horizontally electrochemically depositing metal on a sheet substrate in an intermittent or continuous way.

### BACKGROUND OF THE INVENTION

US 2011/0062028 A1 discloses a method for electrochemically depositing metal on a cathode surface of a crystalline solar cell dedicated to increasing plating rate by simultaneously pulsing electrical power supply and light illumination; and increasing refresh rate of electrolyte solution of surface of a crystalline silicon solar cell.

A common method currently used for generating the metal electrodes of the crystalline silicon solar cell is silk-screen printing technology, which allows the metal slurries (e.g., sliver slurry and aluminum slurry) to be respectively printed on the electrode surface and the anode surface of the crystalline silicon solar cell. After being sintered at a high temperature, the metal electrodes of the crystalline silicon solar cell can be generated. This simple method can be applied in a mass production of the crystalline silicon solar cell.

As the price of the crystalline silicon raw material heavily drops, the cost of the silver slurry comprises a high proportion in the overall cost of manufacturing a crystalline silicon solar cell. Due to the rising price of silver powder, the proportional cost of the silver slurry used in a crystalline silicon solar cell is greater than 15%. Consequently, using a low-priced metal to partially or completely replace the silver slurry would significant lower the cost of a crystalline silicon solar cell.

In the prior art, metal copper is a material capable of replacing the expensive silver slurry. However, metal copper can diffuse into the crystalline silicon under a high temperature environment, sharply decreasing the functional life of the minority carriers of the crystalline silicon. Therefore, metal copper can merely be deposited on the crystalline silicon solar cell at a low temperature to generate the electrodes of a crystalline silicon solar cell.

Due to the temperature limit of metal copper, another method capable of replacing sliver slurry by metal copper is to screen-print a layer of a small quantity of silver slurry on the cathode of the crystalline silicon solar cell. After being sintered at a high temperature, an ohmic contact is generated between the silver slurry and the cathode of the crystalline silicon solar cell, meaning that the metal electrodes of the crystalline silicon solar cell are generated. Subsequently, metal copper can be electromechanically deposited on the silver slurry, thereby satisfying the requirements of collecting and transmitting the electric energy generated by the crystalline silicon solar cell.

Another method capable of replacing silver slurry by metal copper is to directly deposit various metals (e.g., a multi-layer stack composed of nickel, copper and silver) on the crystalline silicon solar cell according to the electrochemical deposition method, thereby generating the metal electrodes of the crystalline silicon solar cell.

Compared with silk-screen printing technology, this electrochemical deposition method is simple and cost effective for generating the metal electrodes of a crystalline silicon solar cell. Therefore, using the electrochemical deposition method to deposit metal on a crystalline silicon solar cell has become the most active research in recent years.

CN 101257059 A discloses a method utilizing the potential difference generated by the crystalline silicon solar cell illuminated by a light source as a means to electrochemically deposit metal on the cathode surface of the crystalline silicon solar cell, namely, the photo-induction electrochemical deposition method. However, this method cannot reliably connect the anode electrons of the crystalline silicon solar cell, which can merely be applied in the laboratory.

CN 102083717 A also discloses a method for connecting the anode electrons of the crystalline silicon solar cell, enabling the electrochemical deposition method to be applied in the mass production of the crystalline silicon solar cell. However, this method has two significant shortcomings: first, the cathode surface of the crystalline silicon solar cell is continuously rubbed with the lower rolling wheels under the action of the upper metal spring rolling wheels, causing damage to the cathode surface of the crystalline silicon solar cell, as well as the metal electrodes generated by the metal electrochemical deposition process; second, this method can only be used to the crystalline silicon solar cells having a screen-printed aluminum back-surface-field (Al-BSF), resulting in a very limited application range.

US 2007/0256937 A1 discloses an electrolytic plating method to form a p-type layer on a substrate for preparing photovoltaic device. The disclosure focuses on how the p-type layer is formed, such as how many layers is required to form the p-type layer and compositions of each layer.

U. S. Patent 4,251,327 discloses an electrolytic plating method on an n-type surface of a crystalline silicon solar cell by photo-induction technology.

WO 2014/076078 A2 discloses a device and method for the chemical or electrolytic treatment of a flat material with a treatment liquid. The device has a treatment chamber, in which the treatment liquid can be accumulated up to a bath level, and a transport device, with which the material to be treated can be transported in the horizontal position in a transport plane below the bath level through the treatment chamber.

In order to improve the photoelectric conversion efficiency, back-passivation technology gradually replaces traditional aluminum back-surface-field technology, thereby enabling the metal electrodes to be generated on the anode of the crystalline silicon solar cell through the metal electrochemical deposition. These disclosed methods can merely electrochemically deposit metal on the cathode of a crystalline silicon solar cell. Thus, when there is a need to generate electrodes on the cathode and the anode of a crystalline silicon solar cell, a separate metal electrochemical deposition process is required for each of them, which is not suitable for a mass production.

### SUMMARY OF THE INVENTION

The purpose of the present invention is to solve the technical problems in the prior art, and provide a method for horizontally electrochemically depositing metal on a sheet substrate, which can be widely applied in various fields and is suitable for a mass production.

The present invention seeks to provide a method for generating metal electrodes by electrochemically depositing metal on a crystalline silicon solar cell. During this process, the cathode surface of the crystalline silicon solar cell is prevented from contacting any solid body, effectively avoiding the damage caused by the friction between the solid bodies to the deposited metal and the cathode surface of the crystalline silicon solar cell.

Another purpose of the present invention is to provide a method for generating metal electrodes by electrochemically depositing metal on a crystalline silicon solar cell, which can simultaneously perform a metal electrochemical deposition process to the cathode surface and the anode surface of the crystalline silicon solar cell, and can simplify the process of generating metal electrodes of a two-sided crystalline silicon solar cell.

The present invention further seeks to provide a method for generating metal electrodes by electrochemically depositing metal on a crystalline silicon solar cell, which is highly applicable and practicable. Namely, this method is capable of separately electroplating the p-type electrode and the n-type electrode of a solar cell, or simultaneously electroplating the p-type electrode and the n-type electrode of a solar cell.

Another purpose of the present invention is to provide a method for generating metal electrodes by electrochemically depositing metal on a crystalline silicon solar cell, and to provide a method for electrochemically depositing metal on various sheet substrates, which can achieve a high applicability and broaden the application of the present invention.

To achieve the above purposes, the present invention adopts the following technical solution:
A method for horizontally electrochemically depositing metal on a cathode surface of a crystalline silicon solar cell, wherein the cathode surface comprises an upper cathode surface and a lower cathode surface, comprising the steps of
- providing an upper metal anode, a lower metal anode, and an electrolyte solution wherein the upper metal anode and the lower metal anode correspond to respectively the upper and the lower cathode surface in the process of electrochemically depositing metal but can be disposed at any suitable place;
- enabling the electrolyte solution to contact the upper metal anode and continuously flow down to the upper cathode surface of the crystalline silicon solar cell being prepared for the metal electrochemical deposition process, thereby disposing an electrolyte solution layer on the upper cathode surface of the crystalline silicon solar cell, wherein the electrolyte solution contacts the upper metal anode, and after the electrolyte solution contacts the upper metal anode, the electrolyte solution is transported to the upper cathode surface and continuously flows down to the upper cathode surface of the crystalline silicon solar cell; and
- soaking the lower metal anode in the electrolyte solution, and having the electrolyte solution in contact with the lower cathode surface of the crystalline silicon solar cell being prepared for the metal electrochemical deposition process; or spraying the electrolyte solution continuously upwards to the lower cathode surface of the crystalline silicon solar cell after the electrolyte solution contacts the lower metal anode.

The upper metal anode is subjected to an oxidation reaction under the effect of a positive potential, losing electrons to generate metal ions, and then it flows down along with the electrolyte solution to the upper surface of the sheet substrate. The metal ions in the electrolyte solution obtain electrons on the cathode surface of the sheet substrate, thereby generating and depositing a metal on the cathode surface of the sheet substrate.

Compared with the prior art, the present invention has the following advantages:
First, the upper metal anode is subjected to an oxidation reaction to generate metal ions, which can be timely transported to the cathode surface by the passing electrolyte solution and greatly improve the validity of the reduction reaction during the process of electrochemically depositing metal. Similarly, the cathode surface is continuously washed by the electrolyte solution flowing from top to bottom in this process, enabling the concentration of the metal ions to be kept uniform at any point on the cathode surface. Thus, the uniformity of the deposited metal can be significantly improved. Further, when the cathode surface is continuously washed by the electrolyte solution flowing from top to bottom, any gas possibly produced in this process can be prevented from accumulating on the cathode surface.
Second, the upper surface of the sheet substrate is protected from being contacted by any solid body during the process of electrochemically depositing metal. When electrochemically depositing metal on the cathode (n-type surface) of a crystalline silicon solar cell, namely, when the sheet substrate is a crystalline silicon solar cell, the present invention can be more advantageous. For instance, the main light-receiving surface of most of the crystalline silicon solar cells is the cathode. Consequently, the quality of the main light-receiving surface (the cathode) can directly determine the photoelectric conversion efficiency of a crystalline silicon solar cell. The metal electrochemical deposition method of the present invention effectively protects the cathode surface of the crystalline silicon solar cell from being contacted by any solid body, thereby eliminating the damage to the cathode surface of the crystalline silicon solar cell.
   A crystalline silicon solar cell can generate electric energy after being illuminated by a light source. When performing the metal electrochemical deposition process of the present invention to the surface of a crystalline silicon solar cell, a photo-induction metal electrochemical deposition method can be utilized. According to this method, the thickness of the electrolyte solution disposed above the cathode of the crystalline silicon solar cell can be very small, which can reduce the light-absorption of the electrolyte solution. Thus, when performing the metal electrochemical deposition method of the present invention, the light energy can be maximally utilized.
Third, the metal electrochemical deposition method can be flexibly used in practical. For instance, a traditional external power supply can be adopted to perform the metal electrochemical deposition process of the present invention. Alternatively, the photo-induction metal electrochemical deposition method can be utilized to perform the metal electrochemical deposition process of the present invention. Further, the external power supply and the photo-induction metal electrochemical deposition method can be simultaneously used to perform the metal electrochemical deposition process of the present invention.

To ensure a closed circuit in the process of electrochemically depositing metal, the position of a metal anode can be altered. For instance, the metal anode can be disposed without directly facing the cathode surface being prepared for the metal electrochemical deposition process.

Additionally, to ensure that the sheet substrate is a crystalline silicon solar cell, the metal electrochemical deposition method of the present invention can be separately performed to the cathode surface and the anode surface of the crystalline silicon solar cell, or simultaneously performed to both the cathode surface and the anode surface of the crystalline silicon solar cell. Thus, the present invention can materialize the simultaneous metal electrochemical deposition.

Furthermore, the metal electrochemical deposition method of the present invention is quite suitable for equipment having a horizontal-advancement structure. According to this equipment, a simple feeding and unloading process can be achieved, greatly facilitating the automation of the whole production line.

Fourth, the metal electrochemical deposition process of the present invention can be performed by simple equipment. During performing the metal electrochemical deposition process of the present invention, an electrolyte solution layer is disposed on the sheet substrate. Relying on the weight of the electrolyte solution layer, the sheet substrate can be tightly attached to a conductive rolling wheel supporting the sheet substrate. Thus, an upper rolling wheel can be removed from the electrolyte solution tank performing the metal electrochemical deposition process of the present invention, which simplifies the structure and saves the cost. This advantage is crucial for a sheet substrate made from a flexible material.

Fifth, the metal electrochemical deposition method of the present invention can be used to electrochemically deposit metal in a continuous way or an intermittent way. Namely, the result generated by a continuous metal electrochemical deposition process or an intermittent metal electrochemical deposition process can be used to the other one. For instance, the result generated by the intermittent metal electrochemical deposition process in the laboratory can be directly used without any modification to equipment having a horizontal-advancement structure in the mass production.

### BRIEF DESCRIPTION OF THE DRAWINGS

To clearly expound the present invention or technical solution, the drawings and embodiments are hereinafter combined to illustrate the present invention. Obviously, the drawings are merely some embodiments of the present invention and those skilled in the art can associate themselves with other drawings without paying creative labor.
Figure 1 is a sectional view illustrating the metal electrochemical deposition method applied in a p-type screen printing cell.
Figure 2 is a sectional view illustrating the metal electrochemical deposition method applied in a conductive sheet substrate.
Figure 3 is a sectional view illustrating the metal electrochemical deposition method of the present invention applied in an n-type two-sided cell.
Figure 4 is a sectional view illustrating the metal electrochemical deposition method of the present invention applied in a p-type solar cell.
Figure 5 is a sectional view illustrating the metal electrochemical deposition method applied in a sheet substrate.

### DETAILED DESCRIPTION OF THE INVENTION

Drawings and detailed embodiments are combined hereinafter to elaborate the technical principles of the present invention.

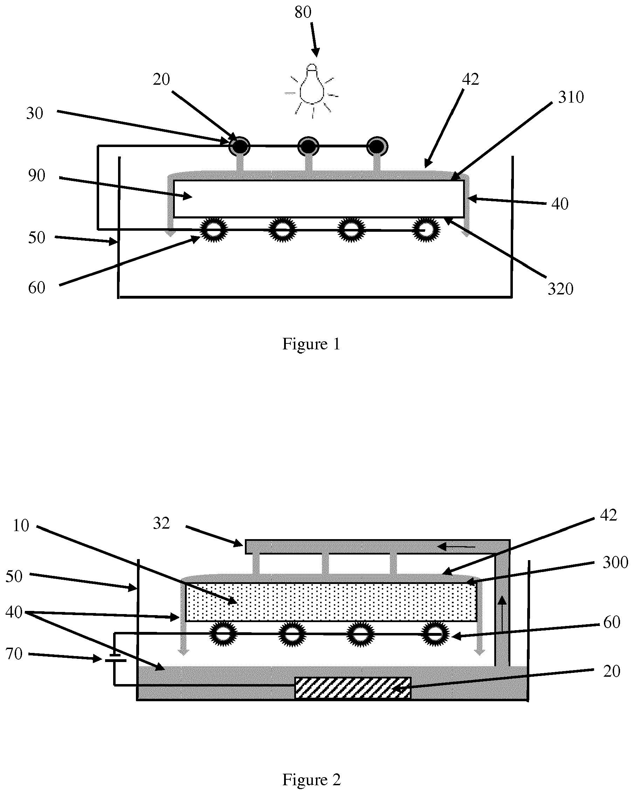

The embodiments of Figures 1 and 2 represent background art useful for understanding the invention.

Figure 1 illustrates an embodiment using photo-induction metal electrochemical deposition method as a means to perform the metal electrochemical deposition process. In this embodiment, the sheet substrate 90 is a p-type crystalline silicon screen-printed solar cell. A p-type crystalline silicon screen-printed solar cell means that the metal electrode 320 of the anode of the cell is generated by sintering after being screen-printed with aluminum slurry. In the configuration of a p-type crystalline silicon screen-printed solar cell 90, the screen-printed aluminum slurry almost covers the anode area of most of the solar cells. When the cathode surface 310 of the p-type crystalline silicon screen-printed solar cell 90 is illuminated by the light source 80 to generate electric energy, a positive potential is generated on the metal electrode 320, which can be transferred to the upper metal anode 20 through the conductive rolling wheels 60 supporting the solar cell. The upper metal anode 20 is subjected to an oxidation reaction under the effect of the positive potential of the p-type crystalline silicon screen-printed solar cell, losing electrons to form metal ions, then it flows down along with the electrolyte solution 40 to the cathode surface of the p-type crystalline silicon screen-printed solar cell. Subsequently, the metal ions in the electrolyte solution 40 receive electrons in the uninsulated area of the cathode surface 310 of the p-type crystalline silicon screen-printed solar cell 90 placed underneath the upper metal anode 20. Thus, a reduction reaction occurs to generate metal, which is deposited in the uninsulated area of the cathode surface 310 of the p-type crystalline silicon screen-printed solar cell, thereby completing a photo-induction electrochemical oxidation-reduction reaction of the metal electrochemical deposition method in this system.

In order to improve the speed of the photo-induction metal electrochemical deposition process, or to lower the luminous intensity of the light source 80 required by the photo-induction metal electrochemical deposition process, an external power supply can be adopted in the embodiment shown in Figure 1. In the application of the metal electrochemical deposition method, the anode of the external power supply is connected to the upper metal anode 20, and the cathode of the external power supply is connected to the conductive rolling wheel 60. Consequently, the electric potential of the external power supply can be utilized to increase the potential difference in the process of electromechanically depositing metal.

In the embodiment shown in Figure 1, the metal electrochemical deposition method is disposing the upper metal anode 20 above the liquid level 42 of the electrolyte solution 40. The upper metal anode 20 is configured to be pipe-shaped. In this arrangement, the electrolyte solution 40 becomes in contact with the inner surface of the upper metal anode 20, and directly flows from the interior the upper metal anode 20 to the cathode surface 310 of the sheet substrate 90 of the metal electrochemical deposition method. The equipment performing the metal electrochemical deposition process can be simplified by this pipe-shaped upper metal anode 20.

In some other embodiments, the upper metal anode 20 can be disposed in the electrolyte solution conduit 30. The electrolyte solution conduit 30 can be made from inert-material pipe, such as plastic pipe or glass pipe. The electrolyte solution 40 contacts the outer surface of the upper metal anode 20, and flows from the electrolyte solution conduit 30 to the upper cathode surface 310 of the sheet substrate 90 of the solar cell of the metal electrochemical deposition method. According to this configuration, the utilization rate of the upper metal anode 20 of the metal electrochemical deposition method can be significantly improved.

In some embodiments, the upper metal anode 20 is disposed higher than the liquid level 42 of the electrolyte solution 40, and in some embodiments, the upper metal anode 20 above the liquid level 42 of the electrolyte solution 40 can also be disposed as low, such that it contacts the liquid level 42 of the electrolyte solution 40.

The electrolyte solution 40 passes through the upper metal anode 20 of the metal electrochemical deposition method of the present invention, and flows to the upper cathode surface 310 of the sheet substrate 90 of the solar cell of the metal electrochemical deposition method. Subsequently, the electrolyte solution 40 flows out from the upper cathode surface 310 of the sheet substrate 90, and returns into the electrolyte solution conduit 30 after being collected by the electrolyte solution tank 50, thereby completing the circulation of the electrolyte solution from the upper metal anode 20 of the metal electrochemical deposition method to the upper cathode surface 310 of the sheet substrate 90 of the metal electrochemical deposition method.

As shown in Figure 1, the sheet substrate 90 is supported by the conductive rolling wheels. In some embodiments of the metal electrochemical deposition method, the rolling wheels 60 can rotate left and right, enabling metal to be uniformly deposited. In other embodiments, the conductive rolling wheels 60 can rotate in one direction. For instance, in equipment having a horizontal-advancement structure in the mass production, the conductive rolling wheels 60 rotating in one direction can continuously complete the metal electrochemical deposition method.

The conductive rolling wheel 60 can be made from metal material. In some embodiments, an insulating material can be used to cover most area without requiring conducting electricity on the metal conductive rolling wheel, which can effectively reduce the loss of the potential difference caused by the short circuit in the process of electrochemically depositing metal. In other embodiments, the conductive rolling wheel can be made from insulating material. Under such circumstances, a conductive material can be used to connect an area having need of conducting electricity on the conductive rolling wheel 60, thereby achieving the conductive effect of the rolling wheel.

In other applications of the metal electrochemical deposition method, the conductive rolling wheels 60 can be changed into a number of solid conductive supporting points. Especially, when performing an intermittent metal electrochemical deposition process, these solid conductive supporting points can effectively simplify the metal electrochemical deposition method.

In addition to the solar cells, the metal electrochemical deposition method can be used for other sheet substrates. As shown in Figure 2, in some embodiments of the metal electrochemical deposition method, the sheet substrate 10 is a conductor. Namely, the conductivity between the upper surface and the lower surface of the sheet substrate is determined by that of the sheet substrate 10.

Further, the upper metal anode is not a metal anode in a general physical meaning of "being disposed above", but an upper metal anode corresponding to the upper surface cathode of the sheet substrate in the process of electrochemically depositing metal. Namely, in the metal electrochemical deposition process, the metal anode, contacts the electrolyte solution subsequently flowing to the upper surface of the sheet substrate 10 ,is called the upper metal anode. Consequently, in the embodiment of performing the metal electrochemical deposition method, the upper metal anode can be disposed at any suitable place. In the embodiment shown in Figure 2, the upper metal anode 20 is disposed at the bottom of the electrolyte solution tank 50. The electrolyte solution 40 becomes in contact with the upper metal anode 20, and is transported to the upper surface of the sheet substrate 10 through a liquid-transporting pipe 32. The liquid-transporting pipe 32 can be installed above the liquid level 42 of the electrolyte solution, or installed at a position very close to the liquid level 42 of the electrolyte solution, or even installed as low as being in contact with the liquid level 42 of the electrolyte solution.

In the embodiment shown in Figure 2, the upper metal anode 20 of the metal electrochemical deposition method is connected to the anode of the power supply 70, and the conductive rolling wheel is connected to the cathode of the power supply 70. The upper metal anode 20 is subjected to an oxidation reaction under the effect of the positive potential of the power supply 70, losing electrons to form metal ions. Subsequently, the metal ions flow down along with the electrolyte solution 40 to the upper surface 300 of the sheet substrate 10. The metal ions in the electrolyte solution 40 get electrons on the upper surface of the sheet substrate 10, thereby producing and depositing metal on the cathode surface of the sheet substrate 10 under the reduction reaction. The sheet substrate 10 continuously obtains electrons from the cathode of the power supply 70 through the conductive rolling wheel 60, thereby completing a whole electrochemical oxidation-reduction reaction of the metal electrochemical deposition method.

In some embodiments, the sheet substrate 10 can be a non-conductor, such as a printed substrate. In these embodiments, the sheet substrate 10 can be specially processed, such as provided with a conductive hole. In this arrangement, a cathode surface can be generated on the sheet substrate 10 under the conduction of the conductive rolling wheel 60 and the action of the negative potential of the cathode of the power supply 70, thereby completing the metal electrochemical deposition method.

In some other embodiments, the sheet substrate 10 can be a rigid substrate, such as a rigid printed substrate. Alternatively, the sheet substrate 10 can be flexible, such as a flexible printed substrate. The metal electrochemical deposition method can effectively prevent the upper surface of the sheet substrate 10 from being contacted by any solid body, thereby avoiding damages to the upper surface of the sheet substrate, which is quite suitable for performing the metal electrochemical deposition to the flexible substrates.

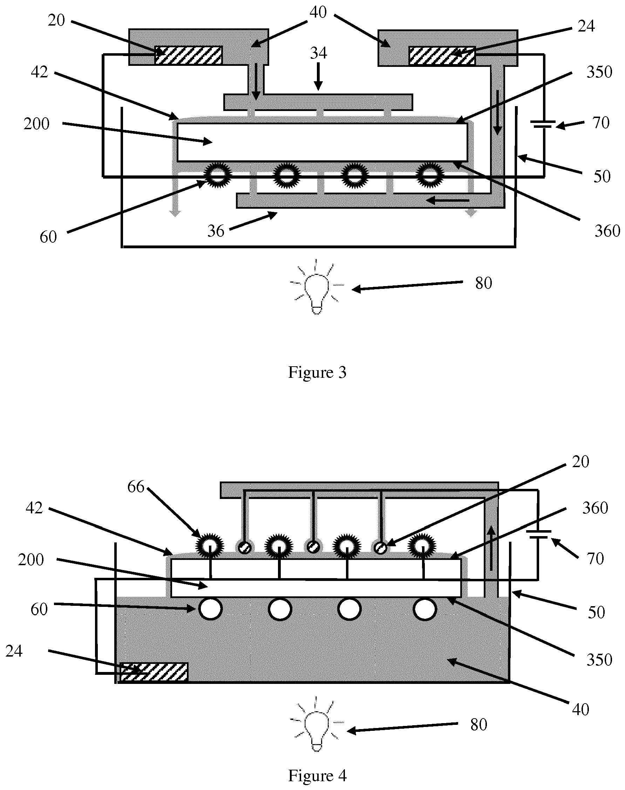

Further, the metal electrochemical deposition method of the present invention can utilize the potential difference produced between the external power supply and the photo-induction light source as a means to simultaneously and separately perform the metal electrochemical deposition process to the two surfaces of the sheet substrate. For example, Figure 3 shows an embodiment of simultaneously performing the metal electrochemical deposition process to the anode and the cathode of an n-type crystalline silicon solar two-sided cell having the anode as the main light-receiving surface according to the metal electrochemical deposition method of the present invention. In this embodiment, the sheet substrate is an n-type crystalline silicon solar two-sided cell 200 having the anode as the main light-receiving surface. As shown in Figure 3, when performing the metal electrochemical deposition method of the present invention, the light source 80 can be disposed underneath the crystalline silicon solar cell 200 as the anode is the main light-receiving surface of the solar cell. The light emitted by the light source 80 can penetrate through the electrolyte solution tank 50, and illuminate on the main light-receiving surface of the n-type crystalline silicon solar two-sided cell 200 having the anode as the main light-receiving surface.

In this embodiment, the upper metal anode 20 and the lower metal anode 24 are disposed above the n-type crystalline silicon solar two-sided cell 200 having the anode as the main light-receiving surface. The electrolyte solution 40 contacts the upper metal anode 20, and is transported through the liquid-transporting pipe 34 to the upper surface of the n-type crystalline silicon solar two-sided cell 200 having the anode as the main light-receiving surface, namely, the cathode surface 350 of the cell 200. Meanwhile, the electrolyte solution 40 becomes in contact with the lower metal anode 24, and is transported through the liquid-transporting pipe 36 to the lower surface of the n-type crystalline silicon solar two-sided cell 200 having the anode as the main light-receiving surface, namely, the anode surface 360 of the cell 200. The liquid-transporting pipe 34 can be installed above the liquid level 42 of the electrolyte solution, or installed at a position very close to the liquid level 42 of the electrolyte solution, or even installed as low as being in contact with the liquid level 42 of the electrolyte solution. The liquid-transporting pipe 36 is installed underneath the n-type crystalline silicon solar two-sided cell 200 having the anode as the main light-receiving surface. Preferably, the liquid-transporting pipe 36 is disposed to be very close to the lower surface of the n-type crystalline silicon solar two-sided cell 200 having the anode as the main light-receiving surface. In this embodiment, the upper metal anode 20 and the lower metal anode 24 are disposed in a relatively concentrated area, which can greatly simplify the equipment performing the metal electrochemical deposition method of the present invention in a mass production.

In order to simultaneously perform the metal electrochemical deposition process to the anode 360 and the cathode 350 of the n-type crystalline silicon solar two-sided cell 200 having the anode as the main light-receiving surface, the anode of the external power supply 70 is connected to the lower metal anode 24, and the cathode of the external power supply 70 is connected to the conductive rolling wheel 60 supporting the sheet substrate 200. Under the action of the external power supply 70 and the conduction of the conductive rolling wheel 60 supporting the sheet substrate 200, the anode 360 of the n-type crystalline silicon solar two-sided cell 200 having the anode as the main light-receiving surface is a cathode relative to the lower metal anode 24 in an electrochemical reaction. Thus, the metal ions in the electrolyte solution 40 receive electrons in the uninsulated area of the anode 360 of the n-type crystalline silicon solar two-sided cell 200 having the anode as the main light-receiving surface, and subsequently produce and deposit metal in the uninsulated area of the anode 360 of the n-type crystalline silicon solar two-sided cell 200 having the anode as the main light-receiving surface.

In this embodiment of the present invention, when the light source 80 is switched on, the n-type crystalline silicon solar two-sided cell 200 having the anode as the main light-receiving surface can generate electric energy. When the electrolyte solution 40 passes through the upper metal anode 20, and flows to the uninsulated area of the surface of the cathode 350 of the n-type crystalline silicon solar two-sided cell 200 having the anode as the main light-receiving surface, the metal ions in the electrolyte solution 40 get electrons to produce and deposit metal in the uninsulated area of the cathode 350 of the n-type crystalline silicon solar two-sided cell 200 having the anode as the main light-receiving surface. Under the action of the anode 360 of the n-type crystalline silicon solar two-sided cell 200 having the anode as the main light-receiving surface, the upper metal anode 20 is subjected to an oxidation reaction, producing metal ions through the conduction of the conductive rolling wheel 60 supporting the sheet substrate 200. Subsequently, the metal ions are dissolved in the electrolyte solution 40, thereby completing a whole electrochemical oxidation-reduction reaction. In this embodiment, when the light source and the external power supply are simultaneously switched on, the system simultaneously performs the photo-induction metal electrochemical deposition process to the surface of the cathode 350 of the n-type crystalline silicon solar two-sided cell 200 having the anode as the main light-receiving surface, and performs the external power supply metal electrochemical deposition process to the surface of the anode 360 of the n-type crystalline silicon solar two-sided cell 200 having the anode as the main light-receiving surface.

In the electrochemical oxidation-reduction reaction, the speed of the electrochemical reaction is determined by the potential difference. During the process of utilizing the photo-induction metal electrochemical deposition method to perform the metal electrochemical deposition process of the present invention, the electric potential generated by the solar cell 200 can be regulated through adjusting the luminous intensity of the light source 80, thereby controlling the speed of depositing metal on the cathode 350 of the solar cell 200. On the other hand, through regulating the electric potential of the power supply 70, the speed of depositing metal on the anode 360 of the solar cell 200 can be controlled. Thus, the speed of depositing metal on the anode 360 and the cathode 350 of the solar cell 200 can be freely controlled.

In other embodiments of the metal electrochemical deposition method of the present invention, the upper metal anode 20 can be changed from being connected to the anode 360 of the n-type crystalline silicon solar two-sided cell 200 having the anode as the main light-receiving surface (namely, the conductive rolling wheel 60 supporting the sheet substrate 200) into being connected with the lower metal anode 24. According to this connecting way, the speed of electrochemically depositing metal on the cathode 350 of the n-type crystalline silicon solar two-sided cell 200 having the anode as the main light-receiving surface can less depend on the luminous intensity of the light source 80.

After slightly modifying embodiment 3, the metal electrochemical deposition method of the present invention can utilize the potential difference produced between the external power supply and the photo-induction power supply as a means to simultaneously and separately perform the metal electrochemical deposition process to the two surfaces of a p-type crystalline silicon solar cell. Figure 4 shows an embodiment of simultaneously performing the metal electrochemical deposition process to the anode and the cathode of the p-type crystalline silicon solar cell having the cathode as the main light-receiving surface by the metal electrochemical deposition method of the present invention. In this embodiment, the sheet substrate is a p-type crystalline silicon solar cell 200 having the cathode as the main light-receiving surface. The p-type crystalline silicon solar cell 200 having the cathode as the main light-receiving surface is supported by insulated rolling wheels 60. As shown in Figure 4, when performing the metal electrochemical deposition method of the present invention, the light source 80 can be disposed underneath the crystalline silicon solar cell 200 as the cathode is the main light-receiving surface of the solar cell. The light emitted by the light source 80 can penetrate through the electrolyte solution tank 50, and illuminate on the main light-receiving surface of the p-type crystalline silicon solar cell 200 having the cathode as the main light-receiving surface.

In this embodiment, the upper metal anode 24 and the lower metal anode 20 are separately disposed above and underneath the p-type crystalline silicon solar cell 200 having the cathode as the main light-receiving surface. In this embodiment, the upper metal anode 24 is disposed above the upper surface of the p-type crystalline silicon solar cell 200 having the cathode as the main light-receiving surface but not in contact with the upper surface of the p-type crystalline silicon solar cell 200 having the cathode as the main light-receiving surface. The electrolyte solution 40 becomes in contact with the upper metal anode 24, and flows to the upper surface of the p-type crystalline silicon solar cell 200 having the cathode as the main light-receiving surface, namely, the anode surface of the solar cell. There's no physical contact between the upper metal anode 24 and the upper surface of the p-type crystalline silicon solar cell 200 having the cathode as the main light-receiving surface. However, when electrolyte solution is existed on the upper surface of the p-type crystalline silicon solar cell 200 having the cathode as the main light-receiving surface, the upper metal anode 24 becomes in contact with the liquid surface of the electrolyte solution due to the small distance between the upper metal anode 24 and the upper surface of the p-type crystalline silicon solar cell 200 having the cathode as the main light-receiving surface. The lower metal anode 20 is disposed underneath the lower surface of the p-type crystalline silicon solar cell 200 having the cathode as the main light-receiving surface, and is directly immersed in the electrolyte solution 40.

In order to simultaneously perform the metal electrochemical deposition process to the anode 360 and the cathode 350 of the p-type crystalline silicon solar cell 200 having the cathode as the main light-receiving surface, the anode of the external power supply 70 is connected to the upper metal anode 24, and the cathode of the external power supply 70 is connected to the conductive rolling wheel 66. Under the action of the external power supply 70 and the conduction of the conductive rolling wheel 66, the anode 360 of the p-type crystalline silicon solar cell 200 having the cathode as the main light-receiving surface is a cathode relative to the upper metal anode 24 in the electrochemical reaction. Thus, the metal ions in the electrolyte solution 40 get electrons in the uninsulated area of the anode 360 of the p-type crystalline silicon solar cell 200 having the cathode as the main light-receiving surface, thereby producing and depositing metal in the uninsulated area of the anode 360 of the p-type crystalline silicon solar cell 200 having the cathode as the main light-receiving surface.

In this embodiment of the present invention, when the light source 80 is switched on, the p-type crystalline silicon solar cell 200 having the cathode as the main light-receiving surface can generate electric energy. The metal ions in the electrolyte solution 40 get electrons on the surface of the cathode 350 of the p-type crystalline silicon solar cell 200 having the cathode as the main light-receiving surface, then produce and deposit metal in the uninsulated area of the cathode 350 of the p-type crystalline silicon solar cell 200 having the cathode as the main light-receiving surface. Under the action of the anode 360 of the p-type crystalline silicon solar cell 200 having the cathode as the main light-receiving surface, the lower metal anode 20 is subjected to an oxidation reaction to produce metal ions through the conduction of the conductive rolling wheel 66. Subsequently, the metal ions are dissolved in the electrolyte solution 40, thereby completing a whole electrochemical oxidation-reduction reaction. In this embodiment, when the light source and the external power supply are simultaneously switched on, the system simultaneously performs the photo-induction metal electrochemical deposition process to the surface of the cathode 350 of the p-type crystalline silicon solar cell 200 having the cathode as the main light-receiving surface, and performs the external power supply metal electrochemical deposition process to the surface of the anode 360 of the p-type crystalline silicon solar cell 200 having the cathode as the main light-receiving surface.

In the electrochemical oxidation-reduction reaction, the speed of the electrochemical reaction is determined by the potential difference. During the process of utilizing the photo-induction metal electrochemical deposition method to perform the metal electrochemical deposition process of the present invention, the electric potential generated by the solar cell 200 can be regulated through adjusting the luminous intensity of the light source 80, thereby controlling the speed of depositing metal on the cathode 350 of the solar cell 200. On the other hand, the speed of depositing metal on the anode 360 of the solar cell 200 can be controlled through regulating the electric potential of the power supply 70. Thus, the speed of depositing metal on the anode 360 and the cathode 350 of the solar cell 200 can be freely controlled.

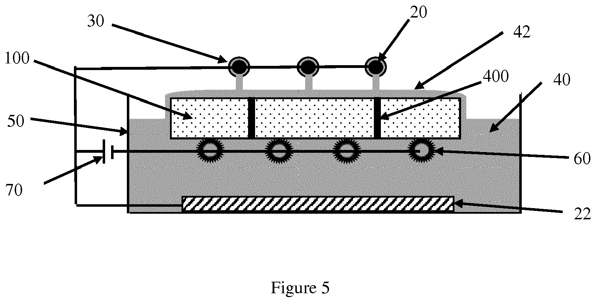

The embodiment of Figure 5 represents background art useful for understanding the invention.

In additional to the two-sided solar cell, the metal electrochemical deposition method can be simultaneously performed to the two surfaces of any sheet substrate. As shown in Figure 5, the sheet substrate 100 adopted in this embodiment is an insulator, and the electric conduction between the upper surface and the lower surface of the sheet substrate 100 is achieved by a conductive hole 400 connecting the upper surface and the lower surface.

In this embodiment, the metal electrochemical deposition method is to the upper metal anode 20 above the liquid level 42 of the electrolyte solution 40. In some embodiments, the upper metal anode 20 can be configured into a pipe shape. In this arrangement, the electrolyte solution 40 flows through the interior of the upper metal anode 20, and directly flows to the upper surface of the sheet substrate 100 of the metal electrochemical deposition method. The pipe-shaped upper metal anode 20 can greatly simplify the equipment performing the metal electrochemical deposition process.

In other embodiments, the upper metal anode 20 can be disposed in the electrolyte solution conduit 30. The electrolyte solution conduit 30 can be made from inert-material pipe, such as plastic pipe or glass pipe. The electrolyte solution 40 flows through the outer surface of the upper metal anode 20, and flows from the electrolyte solution conduit 30 to the upper surface of the sheet substrate 100 of the solar cell of the metal electrochemical deposition method. In this configuration, the utilization rate of the upper metal anode 20 of the metal electrochemical deposition method can be greatly improved.

In some embodiments, the metal anode 20 can be disposed above the liquid level 42 of the electrolyte solution 40. Alternatively, the metal anode 20 placed above the liquid level 42 of the electrolyte solution 40 can be disposed as low as being in contact with the liquid level 42 of the electrolyte liquid 40. In these embodiments, the lower metal anode 22 is disposed at the bottom of the electrolyte solution tank 50, and the liquid level 42 of the electrolyte solution 40 in the electrolyte solution tank 50 is exactly in contact with the lower surface of the sheet substrate 100.

In the embodiment shown in Figure 5, the upper metal anode 20 and the lower metal anode 22 of the metal electrochemical deposition method are simultaneously connected to the anode of the power supply 70, and the conductive rolling wheel 60 supporting the sheet substrate 100 is connected to the cathode of the power supply 70. The upper metal anode 20 and the lower metal anode 22 are subjected to an oxidation reaction, losing electrons to form metal ions under the action of the positive potential of the power supply 70. The metal ions flows down along with the electrolyte solution 40 to the upper surface of the sheet substrate 100, or transported by the electrolyte solution 40 from bottom to top to the lower surface of the sheet substrate under the action of the potential difference. The metal ions in the electrolyte solution 40 get electrons on the cathode surface of the sheet substrate 100, and subjected to a reduction reaction to produce and deposit metal on the cathode surface of the sheet substrate 100. The sheet substrate 100 continuously obtains electrons from the cathode of the power supply 70 through the conductive rolling wheel 60 supporting the sheet substrate 100, thereby completing a whole electrochemical oxidation-reduction reaction of the metal electrochemical deposition method in this system.

In above embodiments, the metal electrochemical deposition method of the present invention can adopt two external power supplies, through which the upper and lower surfaces of the sheet substrate can be separately performed with the metal electrochemical deposition process. Meanwhile, the speed of electrochemically depositing metal on the upper and lower surfaces of the sheet substrate can be separately controlled. For instance, the upper metal anode 20 is connected to the anode of one external power supply, the lower metal anode 22 is connected to the anode of the other external power supply, and the cathodes of the two external power supplies are simultaneously connected to the conductive rolling wheel 60 supporting the sheet substrate 100. The upper metal anode 20 and the lower metal anode 22 are subjected to an oxidation reaction, losing electrons to form metal ions under the action of the positive potential of the two power supplies. Subsequently, the metal ions flows down along with the electrolyte solution 40 to the upper surface of the sheet substrate 100, or transported by the electrolyte solution from bottom to top to the lower surface of the sheet substrate under the action of the potential difference. The metal ions in the electrolyte solution 40 get electrons on the cathode surface of the sheet substrate 100, and subjected to a reduction reaction to produce and deposit metal on the cathode surface of the sheet substrate 100. The sheet substrate 100 continuously obtains electrons from the cathodes of the two external power supplies through the conductive rolling wheels 60 supporting the sheet substrate 100, thereby completing a whole electrochemical oxidation-reduction reaction of the metal electrochemical deposition method in this system. Through regulating the two external power supplies, the speed of electrochemically depositing metal on the upper and lower surfaces of the sheet substrate can be separately controlled by the metal electrochemical deposition method.

According to different applications, the upper metal anode 20 and the lower metal anode 22 of the metal electrochemical deposition method can be insoluble anodes. In these embodiments, the metal ions in the metal electrochemical deposition method are not produced by the upper metal anode 20 or the lower metal anode 22, but provided by the metal oxide dissolved in the electrolyte solution 40.

The description of above embodiments allows those skilled in the art to realize or use the present invention. Although some special terms are used in the description of the present invention, the scope of the invention should not necessarily be limited by this description. The scope of the present invention is defined by the claims.

## Claims

1. A method for horizontally electrochemically depositing metal on a cathode surface (350, 360) of a crystalline silicon solar cell (90, 200), wherein the cathode surface comprises an upper cathode surface and a lower cathode surface, comprising the steps of:
- providing an upper metal anode (20), a lower metal anode (24), and an electrolyte solution (40) wherein the upper metal anode (20) and the lower metal anode (24) correspond to respectively the upper and the lower cathode surface in the process of electrochemically depositing metal but can be disposed at any suitable place;
- enabling the electrolyte solution to contact the upper metal anode and continuously flow down to the upper cathode surface of the crystalline silicon solar cell being prepared for the metal electrochemical deposition process, thereby disposing an electrolyte solution layer on the upper cathode surface of the crystalline silicon solar cell, wherein the electrolyte solution contacts the upper metal anode, and after the electrolyte solution contacts the upper metal anode, the electrolyte solution is transported to the upper cathode surface and continuously flows down to the upper cathode surface of the crystalline silicon solar cell; and
- soaking the lower metal anode in the electrolyte solution, and having the electrolyte solution in contact with the lower cathode surface of the crystalline silicon solar cell being prepared for the metal electrochemical deposition process; or spraying the electrolyte solution continuously upwards to the lower cathode surface of the crystalline silicon solar cell after the electrolyte solution contacts the lower metal anode.

2. The method for horizontally electrochemically depositing metal on the cathode surface of a crystalline silicon solar cell of claim 1, wherein the upper cathode surface of the crystalline silicon solar cell is generated by the cathode surface of the solar cell, which generates electric energy after being illuminated by a light source (80), wherein the lower cathode surface of the crystalline silicon solar cell is generated by the crystalline silicon solar cell after being in contact with the cathode of an external power supply (70).

3. The method for horizontally electrochemically depositing metal on the cathode surface of a crystalline silicon solar cell of claim 1, wherein:
when the upper metal anode is disposed above the upper cathode surface, and the upper metal anode is in contact with the electrolyte solution disposed on the upper cathode surface, after the lower metal anode is soaked in the electrolyte solution, the electrolyte solution contacts the lower cathode surface of the crystalline silicon solar cell being prepared for the metal electrochemical deposition process, or
when the electrolyte solution contacts the lower metal anode and is continuously sprayed upward to the lower cathode surface, the lower metal anode is disposed underneath the crystalline silicon solar cell being prepared for the metal electrochemical deposition process.

4. The method of horizontally electrochemically depositing metal on the cathode surface of a crystalline silicon solar cell of claims 1, 2, or 3, wherein the lower metal anode can be used to perform the metal electrochemical deposition process only to the lower cathode surface, or
the upper metal anode can be used to perform the metal electrochemical deposition only to the upper cathode surface, or
the upper metal anode and the lower metal anode can be simultaneously used to perform the metal electrochemical deposition to all the cathode surfaces of the crystalline silicon solar cell.

5. The method for horizontally electrochemically depositing metal on the cathode surface of a crystalline silicon solar cell of claims 1, 2, 3, or 4, wherein the metal electrochemical deposition process performed on the upper cathode surface of the crystalline silicon solar cell is a photo-induction metal electrochemical deposition process, an external power supply metal electrochemical deposition process, or both processes.

6. The method for horizontally electrochemically depositing metal on the cathode surface of a crystalline silicon solar cell of claim 5, wherein the photo-induction metal electrochemical deposition performed on the upper cathode surface of the crystalline silicon solar cell is assisted by an external power supply (70).

7. The method for horizontally electrochemically depositing metal on the cathode surface of a crystalline silicon solar cell of claims 1, 2, 3, or 4, wherein the electrolyte solution comprises metal ions, acid radical, water and additive.

8. The method for horizontally electrochemically depositing metal on the cathode surface of a crystalline silicon solar cell of claims 1, 2, 3, or 4, wherein the upper metal anode and the lower metal anode are soluble anodes or insoluble anodes, wherein the upper metal anode and the lower metal anode are made from same metal material or different metal materials.

## Patentansprüche

1. Verfahren zur horizontalen elektrochemischen Abscheidung von Metall auf einer Kathodenoberfläche (350, 360) einer kristallinen Siliziumsolarzelle (90, 200), wobei die Kathodenoberfläche eine obere Kathodenoberfläche und eine untere Kathodenoberfläche umfasst, wobei das Verfahren umfasst:
- das Bereitstellen einer oberen Metallanode (20), einer unteren Metallanode (24) und einer Elektrolytlösung (40), wobei die obere Metallanode (20) und die untere Metallanode (24) in dem Verfahren zur elektrochemischen Abscheidung von Metall jeweils der oberen und der unteren Kathodenoberfläche entsprechen, aber an jeder geeigneten Stelle angeordnet werden können;
- das Ermöglichen der Elektrolytlösung, die obere Metallanode zu kontaktieren und hinab zu der oberen Kathodenoberfläche der kristallinen Siliziumsolarzelle, die für das Verfahren zur elektrochemischen Abscheidung von Metall vorbereitet wird, kontinuierlich zu fließen, wodurch eine Elektrolytlösungsschicht auf der oberen Kathodenoberfläche der kristallinen Siliziumsolarzelle angeordnet wird, wobei die Elektrolytlösung die obere Metallanode kontaktiert, und nach dem Kontaktieren der Elektrolytlösung mit der oberen Metallanode, die Elektrolytlösung zu der oberen Kathodenoberfläche transportiert wird und hinab zur oberen Kathodenoberfläche der kristallinen Siliziumsolarzelle kontinuierlich fließt; und
- Tränken der unteren Metallanode in die Elektrolytlösung und In-Kontakt-Setzen der Elektrolytlösung mit der unteren Kathodenoberfläche der kristallinen Siliziumsolarzelle, die für das Verfahren zur elektrochemischen Abscheidung von Metall vorbereitet wird; oder Spritzen der Elektrolytlösung kontinuierlich aufwärts zu der unteren Kathodenoberfläche der kristallinen Siliziumsolarzelle, nach dem Kontakteiren der Elektrolytlösung mit der unteren Metallanode.

2. Verfahren zur horizontalen elektrochemischen Abscheidung von Metall auf der Kathodenoberfläche einer kristallinen Siliziumsolarzelle gemäß Anspruch 1, wobei die obere Kathodenoberfläche der kristallinen Siliziumsolarzelle durch die Kathodenoberfläche der Solarzelle erzeugt wird, welche elektrische Energie erzeugt, nachdem sie durch eine Lichtquelle (80) beleuchtet wurde, wobei die untere Kathodenoberfläche der kristallinen Siliziumsolarzelle durch die kristalline Siliziumsolarzelle erzeugt wird, nachdem sie mit der Kathode einer externen Energieversorgung (70) in Kontakt gesetzt wurde.

3. Verfahren zur horizontalen elektrochemischen Abscheidung von Metall auf der Kathodenoberfläche einer kristallinen Siliziumsolarzelle gemäß Anspruch 1, wobei:
wenn die obere Metallanode oberhalb der oberen Kathodenoberfläche angeordnet ist und die obere Metallanode mit der Elektrolytlösung, welche auf der oberen Kathodenoberfläche angeordnet ist, in Kontakt ist, nachdem die untere Metallanode in die Elektrolytlösung getränkt wurde, die Elektrolytlösung die untere Kathodenoberfläche der kristallinen Siliziumsolarzelle, die für das Verfahren zur elektrochemischen Abscheidung von Metall vorbereitet wird, kontaktiert, oder
wenn die Elektrolytlösung die untere Metallanode kontaktiert und kontinuierlich aufwärts zur unteren Kathodenoberfläche gespritzt wird, die untere Metallanode unterhalb der kristallinen Siliziumsolarzelle, die für das Verfahren zur elektrochemischen Abscheidung von Metall vorbereitet wird, angeordnet wird.

4. Verfahren zur horizontalen elektrochemischen Abscheidung von Metall auf der Kathodenoberfläche einer kristallinen Siliziumsolarzelle gemäß einem der Ansprüche 1, 2 oder 3, wobei die untere Metallanode dazu verwendet werden kann, das Verfahren zur elektrochemischen Abscheidung von Metall nur an der unteren Kathodenoberfläche durchzuführen, oder
die obere Metallanode dazu verwendet werden kann, die elektrochemische Abscheidung von Metall nur an der oberen Kathodenoberfläche durchzuführen, oder
die obere Metallanode und die untere Metallanode gleichzeitig dazu verwendet werden können, die elektrochemische Abscheidung von Metall an allen Kathodenoberflächen der kristallinen Siliziumsolarzelle durchzuführen.

5. Verfahren zur horizontalen elektrochemischen Abscheidung von Metall auf der Kathodenoberfläche einer kristallinen Siliziumsolarzelle gemäß einem der Ansprüche 1, 2, 3 oder 4, wobei das Verfahren zur elektrochemischen Abscheidung von Metall, welches an der oberen Kathodenoberfläche der kristallinen Siliziumsolarzelle durchgeführt wird, ein photoinduziertes Verfahren zur elektrochemischen Abscheidung von Metall, ein Verfahren zur elektrochemischen Abscheidung von Metall mit einer externen Energieversorgung, oder beides ist.

6. Verfahren zur horizontalen elektrochemischen Abscheidung von Metall auf der Kathodenoberfläche einer kristallinen Siliziumsolarzelle gemäß Anspruch 5, wobei das photoinduzierte Verfahren zur elektrochemischen Abscheidung von Metall, das an der oberen Kathodenoberfläche der kristallinen Siliziumsolarzelle durchgeführt wird, von einer externen Energieversorgung (70) unterstützt wird.

7. Verfahren zur horizontalen elektrochemischen Abscheidung von Metall auf der Kathodenoberfläche einer kristallinen Siliziumsolarzelle gemäß einem der Ansprüche 1, 2, 3 oder 4, wobei die Elektrolytlösung Metallionen, Säureradikale, Wasser und Additive umfasst.

8. Verfahren zur horizontalen elektrochemischen Abscheidung von Metall auf der Kathodenoberfläche einer kristallinen Siliziumsolarzelle gemäß einem der Ansprüche 1, 2, 3 oder 4, wobei die obere Metallanode und die untere Metallanode lösliche Anoden oder unlösliche Anoden sind, wobei die obere Metallanode und die untere Metallanode aus dem gleichen Metallmaterial oder aus unterschiedlichen Metallmaterialien gefertigt werden.

## Revendications

1. Procédé de dépôt électrochimique horizontal de métal sur une surface de cathode (350, 360) d'une cellule solaire en silicium cristallin (90, 200), dans lequel la surface de cathode comprend une surface de cathode supérieure et une surface de cathode inférieure, comprenant les étapes suivantes :
- le fait de fournir une anode métallique supérieure (20), une anode métallique inférieure (24) et une solution électrolytique (40), dans lequel l'anode métallique supérieure (20) et l'anode métallique inférieure (24) correspondent respectivement aux surfaces de cathode inférieure et supérieure dans le procédé de dépôt électrochimique de métal mais peuvent être disposées à n'importe quel endroit adéquat ;
- le fait de permettre à la solution électrolytique d'entrer en contact avec l'anode métallique supérieure et de descendre continûment vers la surface de cathode supérieure de la cellule solaire en silicium cristallin qui est préparée pour le procédé de dépôt électrochimique de métal, disposant ainsi une couche de solution électrolytique sur la surface de cathode supérieure de la cellule solaire en silicium cristallin, la solution électrolytique entrant en contact avec l'anode métallique supérieure, et après que la solution électrolytique est entrée en contact avec l'anode métallique supérieure, la solution électrolytique est transportée vers la surface de cathode supérieure et descend continûment vers la surface de cathode supérieure de la cellule solaire en silicium cristallin ; et
- le fait de plonger l'anode métallique inférieure dans la solution électrolytique, et le fait d'avoir la solution électrolytique en contact avec la surface de cathode inférieure de la cellule solaire en silicium cristallin qui est préparée pour le procédé de dépôt électrochimique de métal ; ou le fait de vaporiser la solution électrolytique de manière continue vers le haut vers la surface de cathode inférieure de la cellule solaire en silicium cristallin après que la solution électrolytique est entrée en contact avec l'anode métallique inférieure.

2. Procédé de dépôt électrochimique horizontal de métal sur la surface de cathode d'une cellule solaire en silicium cristallin selon la revendication 1, dans lequel la surface de cathode supérieure de la cellule solaire en silicium cristallin est générée par la surface de cathode de la cellule solaire, laquelle génère de l'énergie électrique après avoir été illuminée par une source de lumière (80), dans lequel la surface de cathode inférieure de la cellule solaire en silicium cristallin est générée par la cellule solaire en silicium cristallin après avoir été en contact avec la cathode d'une alimentation électrique externe (70).

3. Procédé de dépôt électrochimique horizontal de métal sur la surface de cathode d'une cellule solaire en silicium cristallin selon la revendication 1, dans lequel :
quand l'anode métallique supérieure est disposée au-dessus de la surface de cathode supérieure et que l'anode métallique supérieure est en contact avec la solution électrolytique disposée sur la surface de cathode supérieure, après que l'anode métallique inférieure est plongée dans la solution électrolytique, la solution électrolytique entre en contact avec la surface de cathode inférieure de la cellule solaire en silicium cristallin qui est préparée pour le procédé de dépôt électrochimique de métal, ou
quand la solution électrolytique entre en contact avec l'anode métallique inférieure et est vaporisée continûment vers le haut vers la surface de cathode inférieure, l'anode métallique inférieure est disposée en-dessous de la cellule solaire en silicium cristallin qui est préparée pour le procédé de dépôt électrochimique de métal.

4. Procédé de dépôt électrochimique horizontal de métal sur la surface de cathode d'une cellule solaire en silicium cristallin selon l'une des revendications 1, 2 ou 3, dans lequel l'anode métallique inférieure peut être utilisée pour effectuer le procédé de dépôt électrochimique de métal uniquement sur la surface de cathode inférieure, ou
l'anode métallique supérieure peut être utilisée pour effectuer le dépôt électrochimique de métal uniquement sur la surface de cathode supérieure, ou
l'anode métallique supérieure et l'anode métallique inférieure peuvent être utilisées de manière simultanée pour effectuer le dépôt électrochimique de métal sur toutes les surfaces de cathode de la cellule solaire en silicium cristallin.

5. Procédé de dépôt électrochimique horizontal de métal sur la surface de cathode d'une cellule solaire en silicium cristallin selon l'une des revendications 1, 2, 3 ou 4, dans lequel le procédé de dépôt électrochimique de métal effectué sur la surface de cathode supérieure de la cellule solaire en silicium cristallin est un procédé de dépôt électrochimique de métal photo-induit ou un procédé de dépôt électrochimique de métal avec une alimentation électrique externe, ou les deux.

6. Procédé de dépôt électrochimique horizontal de métal sur la surface de cathode d'une cellule solaire en silicium cristallin selon la revendication 5, dans lequel le procédé de dépôt électrochimique de métal photo-induit effectué sur la surface de cathode supérieure de la cellule solaire en silicium cristallin est assisté par une alimentation électrique externe (70).

7. Procédé de dépôt électrochimique horizontal de métal sur la surface de cathode d'une cellule solaire en silicium cristallin selon l'une des revendications 1, 2, 3 ou 4, dans lequel la solution électrolytique comprend des ions métalliques, des radicaux acides, de l'eau et des additifs.

8. Procédé de dépôt électrochimique horizontal de métal sur la surface de cathode d'une cellule solaire en silicium cristallin selon l'une des revendications 1, 2, 3 ou 4, dans lequel l'anode métallique supérieure et l'anode métallique inférieure sont des anodes solubles ou insolubles, dans lequel l'anode métallique supérieure et l'anode métallique inférieure sont faites du même matériau métallique ou de matériaux métalliques différents.
